# EUROPEAN PATENT APPLICATION

(11) **EP 4 831 660 A1**
(43) Date of publication of application: **28.10.2026**
(21) Application number: 26171864.7
(22) Date of filing: 13.04.2026
(51) Int. Cl.: G01R 31/34

(54) **SYSTEM AND METHOD TO DIAGNOSE CONNECTIONS BETWEEN MOTOR DRIVES AND MOTORS**

(30) Priority: 25.04.2025 US 202519189799
(71) Applicant: Rockwell Automation Technologies, Inc., Mayfield Heights, OH 44124 (US)
(72) Inventor: Lanier, Daniel I., Chelmsford, MA 01824 (US); Huang, Yuhong, Chelmsford, MA 01824 (US)
(74) Representative: Grünecker Patent- und Rechtsanwälte PartG mbB

(57) **Abstract**

A system and apparatus for diagnosing motor connections in an independent cart system includes a motor with multiple coils, multiple sensors mounted in the motor, and a motor controller. Each of the sensors corresponds to one of the coils, and each of the sensors generates a feedback signal corresponding to operation of the corresponding coil. The motor controller is configured to selectively energize each coil to control operation of a mover in the independent cart system. The motor controller is further configured to output a voltage to each of the coils, receive the feedback signal from each of the sensors, and verify proper electrical connections between the motor controller and the motor as a function of the voltage output to each of the coils and of the feedback signal received from each of the sensors.

## Description

### BACKGROUND INFORMATION

The subject matter disclosed herein relates to diagnosing connections between motor drives and motors. More specifically, a test signal is provided to each phase of a multi-phase stator to detect proper wiring to each phase without requiring movement of the motor.

Motion control systems utilizing independent cart technology employ a linear drive system embedded within a track and multiple vehicles, also referred to as "movers" or carts, that are propelled along the track via the linear drive system. Movers and linear drive systems can be used in a wide variety of processes (e.g. packaging, manufacturing, and machining) and can provide an advantage over conventional conveyor belt systems with enhanced flexibility, extremely high-speed movement, and mechanical simplicity. The independently controlled movers or carts are each supported on a track for motion along the track. The track is made up of a number of track segments that, in turn, hold individually controllable electric coils. Successive activation of the coils establishes a moving electromagnetic field that interacts with the movers and causes the mover to travel along the track. Sensors may be spaced at fixed positions along the track and/or on the movers to provide information about the position and speed of the movers. Each of the movers may be independently moved and positioned along the track in response to the electromagnetic fields generated by the coils.

Unlike traditional rotary motors, where a stator and rotor are always present, the linear drive system for independent cart technology includes portions of the track where movers are present and other portions of the track where movers are not present. In a linear drive system, the movers have similar function to the rotor in a rotary motor. In the linear drive system, excitation of the coils along the track create the moving electromagnetic field which interacts with permanent magnets present on the mover to cause the mover to travel along the track. In a rotary motor system, a rotor is always present and, therefore, excitation of the coils in the stator cause rotation of the rotor within the motor. Because there are sections of track in a linear drive system with no movers present, excitation of the coils in a linear drive system do not necessarily result in motion for the independent cart system.

Traditional methods of checking for correct wiring connections between motors and drives rely on feedback corresponding to the angular position of the rotor. For example, excitation of the stator coils in a first sequence should cause rotation in a first direction, and excitation of the stator coils in a second sequence should cause rotation in a second direction. A motor drive may be configured to receive position feedback from an encoder mounted on the rotor to verify that the motor is rotating in the desired direction according to the sequence in which the stator coils are energized. In contrast, however, exciting the stator coils along a track segment with no mover present, results in no motion for the independent cart system. The segment controller is unable to rely on feedback corresponding to motion in the linear drive system to determine whether the wiring between the segment controller and coils is correct.

Thus, it would be desirable to provide an improved system and method for diagnosing electrical connections between motor drives and motors.

### BRIEF DESCRIPTION

According to one embodiment of the invention, an apparatus for diagnosing motor connections in an independent cart system includes a motor with multiple coils, multiple sensors mounted in the motor, and a motor controller. Each of the sensors corresponds to at least one of the coils, and each of the sensors generates a feedback signal corresponding to operation of the corresponding coil. The motor controller is configured to selectively energize each coil to control operation of a mover in the independent cart system. The motor controller is further configured to output a voltage to each of the coils, receive the feedback signal from each of the sensors, and verify proper electrical connections between the motor controller and the motor as a function of the voltage output to each of the coils and of the feedback signal received from each of the sensors.

According to another embodiment of the invention, a method for diagnosing motor connections in an independent cart system is disclosed, where the independent cart system includes multiple track segments and multiple movers operative to travel along the track segments. A desired coil, selected from a plurality of coils spaced along a length of a track segment, is energized with a segment controller mounted in the track segment. The desired coil varies among each of the coils according to a diagnostic sequence. A feedback signal is received at the segment controller from a sensor mounted on the track segment, where multiple sensors are mounted along the length of the track segment. Each of the sensors correspond to at least one of the coils, and the feedback signal is generated by the sensor responsive to the corresponding coil being energized by the segment controller. The feedback signal received is verified as corresponding to the desired coil being energized.

According to still another embodiment of the invention, an apparatus for diagnosing electrical connections in an independent cart system includes multiple movers and multiple track segments. Each of the movers includes at least one drive magnet defining one portion of a linear drive system to propel the corresponding mover within the independent cart system. The track segments define a track for the independent cart system along which the plurality of movers travel. Each track segment includes multiple coils extending along a length of the corresponding track segment, multiple sensors mounted along the length of the corresponding track segment, and a segment controller. The coils define another portion of the linear drive system to propel the movers along the track. Each sensor corresponds to at least one of the coils, and each sensor generates a feedback signal corresponding to operation of the corresponding coil. The segment controller is configured to selectively energize each of the coils, receive the feedback signal from each of the sensors, and verify proper electrical connections to each of the coils as a function of the feedback signal received from each sensor and of the selectively energized coils.

These and other advantages and features of the invention will become apparent to those skilled in the art from the detailed description and the accompanying drawings. It should be understood, however, that the detailed description and accompanying drawings, while indicating preferred embodiments of the present invention, are given by way of illustration and not of limitation. Many changes and modifications may be made within the scope of the present invention without departing from the spirit thereof, and the invention includes all such modifications.

### BRIEF DESCRIPTION OF THE DRAWINGS

Various exemplary embodiments of the subject matter disclosed herein are illustrated in the accompanying drawings in which like reference numerals represent like parts throughout, and in which:
FIG. 1 is a is a schematic representation of an exemplary control system for an independent cart system according to one embodiment of the invention;
FIG. 2 is a sectional view of one embodiment of a mover and track segment included in the linear drive system taken at 2-2 of Fig. 1;
FIG. 3 is a partial top cutaway view of the mover and track segment of Fig. 1 with position sensors illustrated along a length of the track segment;
FIG. 4 is a partial top cutaway view of the mover and track segment of Fig. 1 with thermal sensors illustrated along a length of the track segment;
FIG. 5 is a partial top cutaway view of the mover and track segment of Fig. 1 with current sensors illustrated along a length of the track segment;
FIG. 6 is a block diagram representation of the exemplary control system of Fig. 1;
FIG. 7A is a graphical representation of a first series of pulses provided to coils along a track segment;
FIG. 7B is a graphical representation of a set of sensors corresponding to the coils energized in Fig. 7A providing a correct set of feedback signals for the first series of pulses;
FIG. 8A is a graphical representation of a second series of pulses provided to coils along a track segment;
FIG. 8B is a graphical representation of a set of sensors corresponding to the coils energized in Fig. 8A providing a correct set of feedback signals for the second series of pulses;
FIG. 9A is a graphical representation of the first series of pulses provided to coils along a track segment;
FIG. 9B is a graphical representation of a set of sensors corresponding to the coils energized in Fig. 9A providing a set of feedback signals for the first series of pulses which indicate the wiring to the first coil and the second coil are swapped;
FIG. 10A is a graphical representation of the first series of pulses provided to coils along a track segment;
FIG. 10B is a graphical representation of a set of sensors corresponding to the coils energized in Fig. 10A providing a set of feedback signals for the first series of pulses which indicate the wiring between the first coil and the second coil is shorted together;
FIG. 11A is a graphical representation of the first series of pulses provided to coils along a track segment;
FIG. 11B is a graphical representation of a set of sensors corresponding to the coils energized in Fig. 11A indicating the cabling between the sensors and the segment controller is disconnected;
FIG. 12A is a graphical representation of the first series of pulses provided to coils along a track segment;
FIG. 12B is a graphical representation of a set of sensors corresponding to the coils energized in Fig. 12A providing a set of feedback signals for the first series of pulses which indicate a fault with the second coil, a fault with the second sensor, of a disconnected wire between the second sensor and the segment controller; and
FIG. 13 is a schematic representation of sensors mounted within a stator of a rotary motor.

In describing the various embodiments of the invention which are illustrated in the drawings, specific terminology will be resorted to for the sake of clarity. However, it is not intended that the invention be limited to the specific terms so selected and it is understood that each specific term includes all technical equivalents which operate in a similar manner to accomplish a similar purpose. For example, the word "connected," "attached," or terms similar thereto are often used. They are not limited to direct connection but include connection through other elements where such connection is recognized as being equivalent by those skilled in the art.

### DETAILED DESCRIPTION

The various features and advantageous details of the subject matter disclosed herein are explained more fully with reference to the non-limiting embodiments described in detail in the following description.

The subject matter disclosed herein describes an improved system and method for diagnosing electrical connections between motor drives and motors. A sensor is provided on the motor for each coil of the motor. In one embodiment, a sensor is provided for each coil. In another embodiment, one sensor may be configured to detect energization of multiple coils. The sensor is configured to generate a feedback signal corresponding to energization of the coil. The sensor may be, but is not limited to, a magnetic field sensor, a current sensor, and a temperature sensor. The motor controller is configured to energize each coil of the motor, and the sensor generates a feedback signal responsive to the coil being energized. The energization of each coil may be sequential, according to a pattern, or in any other suitable order to verify that each coil has been properly connected to the motor controller. The energization of each coil may additionally be configured in a manner to prevent motion of a mover, if present, along the track segment. Optionally, the energization may occur in a manner which would cause minimal movement of the mover, if present, along the track segment. In either instance, the sensors generate the feedback signal responsive to energization of the corresponding coil. It is, therefore, a feature of this invention to diagnose electrical connections between a motor drive and a motor without using position feedback information corresponding to motion of the motor.

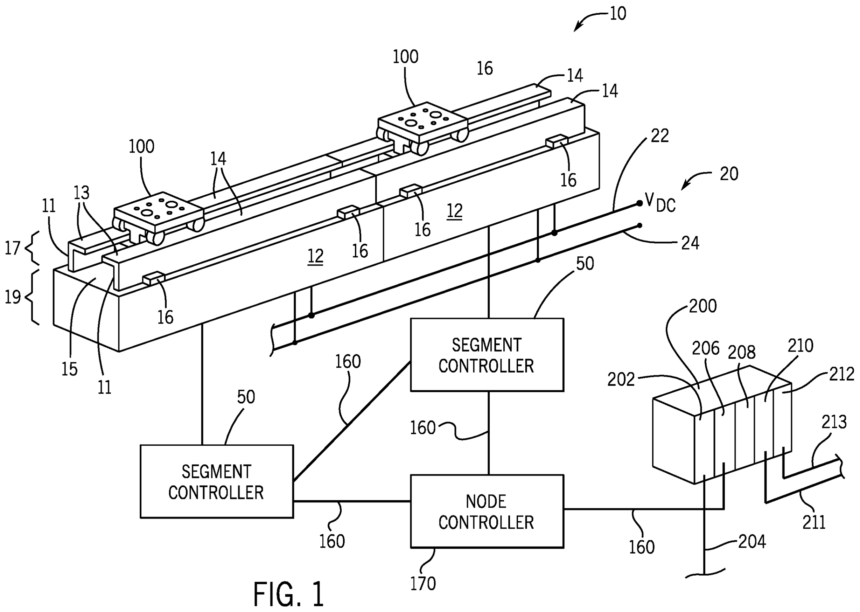

Tuming initially to Fig. 1, an exemplary transport system for moving articles or products includes a track 10 made up of multiple segments 12. According to the illustrated embodiment, multiple segments 12 are joined end-to-end to define the overall track configuration. The illustrated segments 12 are both straight segments having generally the same length. It is understood that track segments of various sizes, lengths, and shapes may be connected together to form the track 10 without deviating from the scope of the invention. The track 10 is illustrated in a horizontal plane. For convenience, the horizontal orientation of the track 10 shown in Fig. 1 will be discussed herein. Terms such as upper, lower, inner, and outer will be used with respect to the illustrated track orientation. These terms are relational with respect to the illustrated track and are not intended to be limiting. It is understood that the track may be installed in different orientations, such as sloped or vertical, and include different shaped segments including, but not limited to, straight segments, inward bends, outward bends, up slopes, down slopes, right-hand switches, left-hand switches, and various combinations thereof. The width of the track 10 may be greater in either the horizontal or vertical direction according to application requirements. The movers 100 will travel along the track and take various orientations according to the configuration of the track 10 and the relationships discussed herein may vary accordingly.

According to the illustrated embodiment, the track receives power from a distributed DC voltage. A DC bus 20 receives a DC voltage, VDC, from a DC supply and conducts the DC voltage to each track segment 12. The illustrated DC bus 20 includes two voltage rails 22, 24 across which the DC voltage is present. The DC supply may include, for example, a rectifier front end configured to receive a single or multi-phase AC voltage at an input and to convert the AC voltage to the DC voltage. It is contemplated that the rectifier section may be passive, including a diode bridge or, active, including, for example, transistors, thyristors, silicon-controlled rectifiers, or other controlled solid-state devices. Although illustrated external to the track segment 12, it is contemplated that the DC bus 20 would extend within the lower portion 19 of the track segment. Each track segment 12 includes connectors to which either the DC supply or another track segment may be connected such that the DC bus 20 may extend for the length of the track 10. Optionally, each track segment 12 may be configured to include a rectifier section (not shown) and receive an AC voltage input. The rectifier section in each track segment 12 may convert the AC voltage to a DC voltage utilized by the corresponding track segment.

Each track segment 12 includes an upper portion 17 and a lower portion 19. The upper portion 17 is configured to carry the movers 100 and the lower portion 19 is configured to house the control elements. As illustrated, the upper portion 17 includes a pair of rails 14 extending longitudinally along the upper portion 17 of each track segment 12 and defining a channel 15 between the two rails. Clamps 16 affix to the sides of the rails 14 and secure the rails 14 to the lower portion 19 of the track segment 12. Each rail 14 is generally L-shaped with a side segment 11 extending in a generally orthogonal direction upward from the lower portion 19 of the track segment 12, and a top segment 13 extending inward toward the opposite rail 14. The top segment 13 extends generally parallel to the lower portion 19 of the track segment 12 and generally orthogonal to the side segment 11 of the rail 14. Each top segment 13 extends toward the opposite rail 14 for only a portion of the distance between rails 14, leaving a gap between the two rails 14. The gap and the channel 15 between rails 14 define a guideway along which the movers 100 travel.

According to one embodiment, the surfaces of the rails 14 and of the channel 15 are planar surfaces along which wheels 255, 260, 265 from the mover 100 travel. The surfaces of the rails 14 and channel 15 may be made of a long-wearing, rigid material to provide low wear from the wheels 255, 260, 265 of the mover 100 traveling along the surfaces. The wheels 255, 260, 265 are similarly made of a long-wearing, low-wear material such that the contacting surfaces between the movers 100 and the track segment 12 generate little particulate matter as the mover 100 travels along the track 10. According to one aspect of the invention, the wheels 255, 260, 265 may be manufactured of a polyurethane or a polyamide material to provide both long wear and vibration dampening properties for the mover 100. Various other combinations of shapes and materials for construction of the track segment 12 and mover 100 may be utilized without deviating from the scope of the invention.

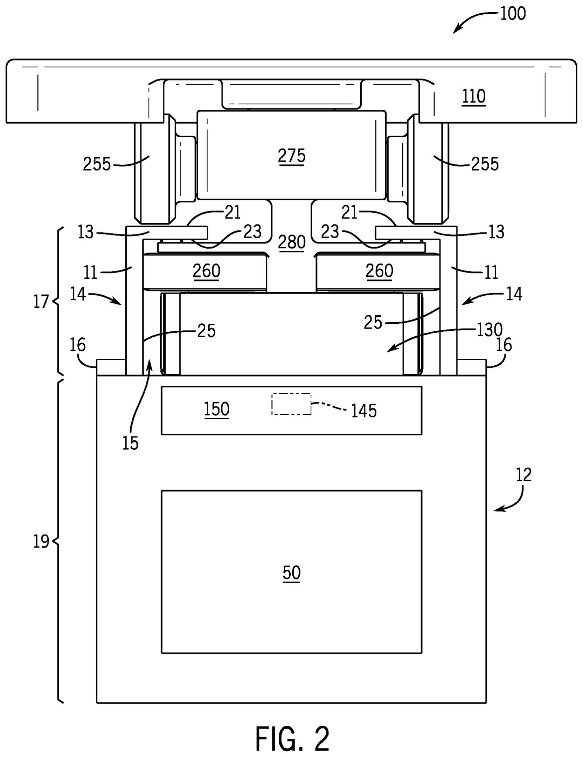

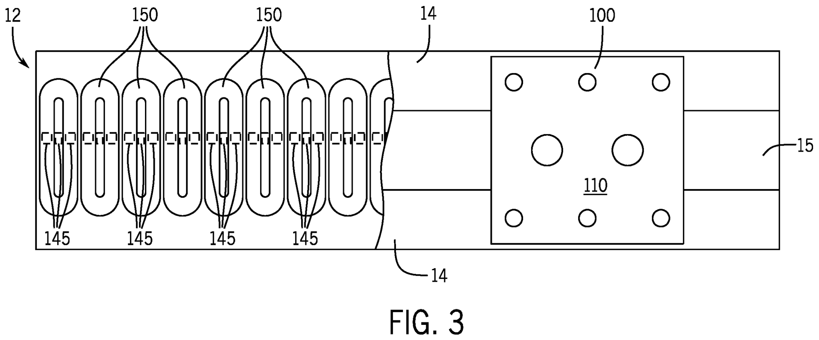

The mover 100 is carried along the track 10 by a linear drive system. The linear drive system is incorporated in part on each mover 100 and in part within each track segment 12. A first portion of the linear drive system includes one or more drive magnets 130 mounted to each mover 100. With reference to Fig. 2, the drive magnets 130 are arranged in a block on the lower surface of each mover. The linear drive system further includes a series of coils 150 spaced along the length of the track segment 12. With reference also to Fig 3, the coils 150 may be positioned within a housing for the lower portion 19 of the track segment 12 and below the surface of the channel 15. The coils 150 are energized sequentially according to the configuration of the drive magnets 130 present on the movers 100. The sequential energization of the coils 150 generates a moving electromagnetic field that interacts with the magnetic field of the drive magnets 130 to propel each mover 100 along the track segment 12.

A segment controller 50 is provided within each track segment 12 to control the linear drive system and to achieve the desired motion of each mover 100 along the track segment 12. The segment controller 50 for each track segment 12 regulates current in the coils 150 to generate an electromagnetic field. Further, the segment controller 50 selectively energizes coils 150 along a length of the track segment 12 to create a moving electromagnetic field. This moving electromagnetic field interacts with the magnetic field generated by the drive magnets 130 on each mover 100 to cause the movers 100 to travel along the track segment. Regulating the current such that the electromagnetic field moves along the track segment 12 in a first direction causes the mover 100 to travel in the first direction, and regulating the current such that the electromagnetic field moves along the track segment 12 in the opposite direction causes the mover 100 to travel in the opposite direction.

Although illustrated in Fig. 1 as blocks external to the track segments 12, the arrangement is to facilitate illustration of interconnects between controllers. As shown in Fig. 2, it is contemplated that each segment controller 50 may be mounted in the lower portion 19 of the track segment 12. Each segment controller 50 is in communication with a node controller 170 which is, in turn, in communication with an industrial controller 200. The industrial controller may be, for example, a programmable logic controller (PLC) configured to control elements of a process line stationed along the track 10. The process line may be configured, for example, to fill and label boxes, bottles, or other containers loaded onto or held by the movers 100 as they travel along the line. In other embodiments, robotic assembly stations may perform various assembly and/or machining tasks on workpieces carried along by the movers 100. The exemplary industrial controller 200 includes: a power supply 202 with a power cable 204 connected, for example, to a utility power supply; a communication module 206 connected by a network medium 160 to the node controller 170; a processor module 208; an input module 210 receiving input signals 211 from sensors or other devices along the process line; and an output module 212 transmitting control signals 213 to controlled devices, actuators, and the like along the process line. The processor module 208 may identify when a mover 100 is required at a particular location and may monitor sensors, such as proximity sensors, position switches, or the like to verify that the mover 100 is at a desired location. The processor module 208 transmits the desired locations of each mover 100 to a node controller 170 where the node controller 170 operates to generate commands for each segment controller 50.

A position feedback system provides knowledge of the location of each mover 100 along the length of the track segment 12 to the segment controller 50. According to one embodiment of the invention, the position feedback system includes one or more position magnets mounted to the mover 100. According to another embodiment of the invention, the position feedback system utilizes the drive magnets 130 as position magnets. Position sensors 145 are positioned along the track segment 12 at a location suitable to detect the magnetic field generated by the drive magnets 130. With reference to Figs 2 and 3, the position sensors 145 are located below or interspersed with the coils 150. The sensors 145 are positioned within the track segment 12 such that each of the drive magnets 130 are proximate to the sensor as the mover 100 passes each sensor 145. The sensors 145 are a suitable magnetic field detector including, for example, a Hall Effect sensor, a magneto-diode, an anisotropic magnetoresistive (AMR) device, a giant magnetoresistive (GMR) device, a tunnel magnetoresistance (TMR) device, fluxgate sensor, or other microelectromechanical (MEMS) device configured to generate an electrical signal corresponding to the presence of a magnetic field. The magnetic field sensor 145 outputs a feedback signal provided to the segment controller 50 for the corresponding track segment 12 on which the sensor 145 is mounted. The position sensors 145 are spaced apart along the length of the track. According to one aspect of the invention, the position sensors 145 are spaced apart such that adjacent position sensors 145 generate a feedback signal which is offset from each other by ninety electrical degrees (90°). Multiple position sensors 145 are, therefore, generating feedback signals in tandem for a single mover 100 as the mover is travelling along the track 10.

Each controller (i.e., the segment controller 50, the node controller 170, and the programmable logic controller 200) includes at least one processor and non-transitory memory. The non-transitory memory stores instructions for execution by the processor within the controller. It is contemplated that the processor and non-transitory memory may each be a single electronic device or formed from multiple devices. The processor may be a microprocessor. Optionally, the processor and/or the non-transitory memory may be integrated on a field programmable gate array (FPGA) or an application specific integrated circuit (ASIC). The instructions include one or modules, control programs, and/or an operating system to achieve the desired functions of the corresponding controller. Although certain features of the present invention are discussed herein as being performed by specific controllers, in alternate embodiments, some features may be performed by another controller within the system.

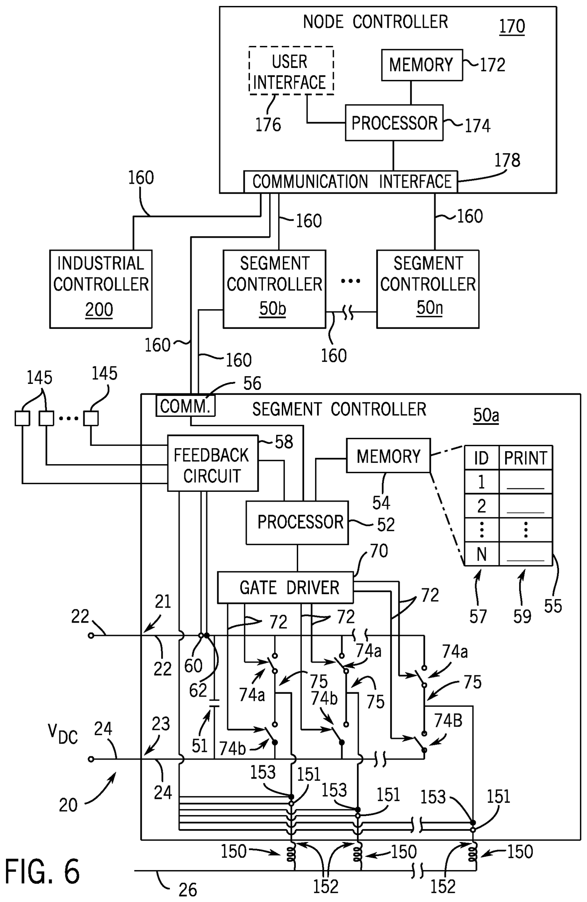

With reference also to Fig. 6, the node controller 170 includes a processor 174 and a memory device 172. It is contemplated that the processor 174 and memory device 172 may each be a single electronic device or formed from multiple devices. The processor 174 may be a microprocessor. Optionally, the processor 174 and/or the memory device 172 may be integrated on a field programmable gate array (FPGA) or an application specific integrated circuit (ASIC). The memory device 172 may include volatile memory, non-volatile memory, or a combination thereof. An optional user interface 176 may be provided for an operator to configure the node controller 170 and to load or configure desired motion profiles for the movers 100 on the node controller 170. Optionally, the configuration may be performed via a remote device connected via a network and a communication interface 178 to the node controller 170. It is contemplated that the node controller 170 and user interface 176 may be a single device, such as a laptop, notebook, tablet or other mobile computing device. Optionally, the user interface 176 may include one or more separate devices such as a keyboard, mouse, display, touchscreen, interface port, removable storage medium or medium reader and the like for receiving information from and displaying information to a user. Optionally, the node controller 170 and user interface may be an industrial computer mounted within a control cabinet and configured to withstand harsh operating environments. It is contemplated that still other combinations of computing devices and peripherals as would be understood in the art may be utilized or incorporated into the node controller 170 and user interface 176 without deviating from the scope of the invention.

The node controller 170 includes one or more programs stored in the memory device 172 for execution by the processor 174. The node controller 170 receives a desired position from the industrial controller 200 and determines one or more motion profiles for the movers 100 to follow along the track 10. A program executing on the processor 174 is in communication with each segment controller 50 on each track segment via a network medium 160. The node controller 170 may transfer a desired motion profile to each segment controller 50. Optionally, the node controller 170 may be configured to transfer the information from the industrial controller 200 identifying one or more desired movers 100 to be positioned at or moved along the track segment 12, and the segment controller 50 may determine the appropriate motion profile for each mover 100. Various features of the present application will be discussed herein as being executed within the segment controller 50, the industrial controller 200, and the node controller 170. As illustrated in Figs. 1 and 6, these controllers are interconnected by the network media 160. According to other, non-illustrated embodiments of the invention, various features discussed herein as implemented on one of the controllers 50, 200, 170 may be implemented on another controller with communication via the network media 160 transmitting data required to perform the functions between the various controllers.

The segment controller 50 also includes a communication interface 56 that receives communications from the node controller 170 and/or from adjacent segment controllers 50. The communication interface 56 extracts data from the message packets on the industrial network and passes the data to a processor 52 executing in the segment controller 50. The processor may be a microprocessor. Optionally, the processor 52 and/or a memory device 54 within the segment controller 50 may be integrated on a field programmable gate array (FPGA) or an application specific integrated circuit (ASIC). It is contemplated that the processor 52 and memory device 54 may each be a single electronic device or formed from multiple devices. The memory device 54 may include volatile memory, non-volatile memory, or a combination thereof. The segment controller 50 receives the motion profile or desired motion of the movers 100 and utilizes the motion commands to control movers 100 along the track segment 12 controlled by that segment controller 50.

Each segment controller 50 generates switching signals to generate a desired current and/or voltage at each coil 150 in the track segment 12 to achieve the desired motion of the movers 100. The switching signals 72 control operation of switching devices 74 for the segment controller 50. According to the illustrated embodiment, the segment controller 50 includes a dedicated gate driver module 70 which receives command signals from the processor 52, such as a desired voltage and/or current to be generated in each coil 150, and generates the switching signals 72. Optionally, the processor 52 may incorporate the functions of the gate driver module 70 and directly generate the switching signals 72. The switching devices 74 may be a solid-state device that is activated by the switching signal, including, but not limited to, transistors, thyristors, or silicon-controlled rectifiers.

According to the illustrated embodiment, the track receives power from a distributed DC voltage. A DC bus 20 receives a DC voltage, VDC, from a DC supply and conducts the DC voltage to each track segment 12. The illustrated DC bus 20 includes two voltage rails 22, 24 across which the DC voltage is present. The DC supply may include, for example, a rectifier front end configured to receive a single or multi-phase AC voltage at an input and to convert the AC voltage to the DC voltage. It is contemplated that the rectifier section may be passive, including a diode bridge or, active, including, for example, transistors, thyristors, silicon-controlled rectifiers, or other controlled solid-state devices. Although illustrated external to the track segment 12, it is contemplated that the DC bus 20 would extend within the lower portion 19 of the track segment. Each track segment 12 includes connectors to which either the DC supply or another track segment may be connected such that the DC bus 20 may extend for the length of the track 10. Optionally, each track segment 12 may be configured to include a rectifier section (not shown) and receive an AC voltage input. The rectifier section in each track segment 12 may convert the AC voltage to a DC voltage utilized by the corresponding track segment.

The DC voltage from the DC bus 20 is provided at the input terminals 21, 23 to a power section for the segment controller. A first voltage potential is present at the first input terminal 21 and a second voltage potential is present at the second input terminal 23. The DC bus extends into the power section defining a positive rail 22 and a negative rail 24 within the segment controller. The terms positive and negative are used for reference herein and are not meant to be limiting. It is contemplated that the polarity of the DC voltage present between the input terminals 21, 23 may be negative, such that the potential on the negative rail 24 is greater than the potential on the positive rail 22. Each of the voltage rails 22, 24 are configured to conduct a DC voltage having a desired potential, according to application requirements. According to one embodiment of the invention, the positive rail 22 may have a DC voltage at a positive potential and the negative rail 24 may have a DC voltage at ground potential. Optionally, the positive rail 22 may have a DC voltage at ground potential and the negative rail 24 may have a DC voltage at a negative potential According to still another embodiment of the invention, the positive rail 22 may have a first DC voltage at a positive potential with respect to the ground potential and the negative rail 24 may have a second DC voltage at a negative potential with respect to the ground potential. The resulting DC voltage potential between the two rails 22, 24 is the difference between the potential present on the positive rail 22 and the negative rail 24.

It is further contemplated that the DC supply may include a third voltage rail 26 having a third voltage potential. According to one embodiment of the invention, the positive rail 22 has a positive voltage potential with respect to ground, the negative rail 24 has a negative voltage potential with respect to ground, and the third voltage rail 26 is maintained at a ground potential. Optionally, the negative voltage rail 24 may be at a ground potential, the positive voltage rail 22 may be at a first positive voltage potential with respect to ground, and the third voltage rail 26 may be at a second positive voltage potential with respect to ground, where the second positive voltage potential is approximately one half the magnitude of the first positive voltage potential. With such a split voltage DC bus, two of the switching devices 74 may be used in pairs to control operation of one coil 150 by alternately provide positive or negative voltages to one the coils 150.

The power section in each segment controller 50 may include multiple legs, where each leg is connected in parallel between the positive rail 22 and the negative rail 24. According to the illustrated embodiment, three legs are shown. However, the number of legs may vary and will correspond to the number of coils 150 extending along the track segment 12. Each leg includes a first switching device 74a and a second switching device 74b connected in series between the positive rail 22 and the negative rail 24 with a common connection 75 between the first and second switching devices 74a, 74b. The first switching device 74a in each leg may also be referred to herein as an upper switch, and the second switching device 74b in each leg may also be referred to herein as a lower switch. The terms upper and lower are relational only with respect to the schematic representation and are not intended to denote any particular physical relationship between the first and second switching devices 74a, 74b. The switching devices 74 include, for example, power semiconductor devices such as transistors, thyristors, and silicon-controlled rectifiers, which receive the switching signals 72 to turn on and/or off. Each of switching devices may further include a diode connected in a reverse parallel manner between the common connection 75 and either the positive or negative rail 22, 24.

The processor 52 also receives feedback signals from sensors providing an indication of the operating conditions within the power segment or of the operating conditions of a coil 150 connected to the power segment. According to the illustrated embodiment, the power segment includes a voltage sensor 62 and a current sensor 60 at the input of the power segment. The voltage sensor 62 generates a voltage feedback signal and the current sensor 60 generates a current feedback signal, where each feedback signal corresponds to the operating conditions on the positive rail 22. The segment controller 50 also receives feedback signals corresponding to the operation of coils 150 connected to the power segment. A voltage sensor 153 and a current sensor 151 are connected in series with the coils 150 at each output of the power section. The voltage sensor 153 generates a voltage feedback signal and the current sensor 151 generates a current feedback signal, where each feedback signal corresponds to the operating condition of the corresponding coil 150. The processor 52 executes a program stored on the memory device 54 to regulate the current and/or voltage supplied to each coil and the processor 52 and/or gate driver module 70 generates switching signals 72 which selectively enable/disable each of the switching devices 74 to achieve the desired current and/or voltage in each coil 150. The energized coils 150 create an electromagnetic field that interacts with the drive magnets 130 on each mover 100 to control motion of the movers 100 along the track segment 12.

As discussed above, the segment controller 50 also receives feedback signals corresponding to the operation of each coil 150 along the track segment 12, where each feedback signal corresponds to operation of at least one coil 150. With reference again to Fig. 3, each sensor may be one of the magnetic position sensors 145 spaced along the length of the track segment 12. According to the illustrated embodiment, three position sensors 145 are spaced proximate each coil 150. It is contemplated that various other numbers of position sensors 145 may be spaced proximate each coil 150. Further, the position sensors 145 are spaced apart according to the arrangement of drive magnets 130 on each mover 100 rather than on the geometry of each coil 150. Therefore, the number of position sensors 145 may vary, for example, plus or minus one sensor for adjacent coils 150. A single position sensor 145 corresponding to each coil 150 may be selected or multiple position sensors 145, where each of the multiple position sensors 145 are proximate the same coil 150, may be selected for determining correct electrical connections to each coil 150. For larger movers 100, a drive magnet 130 may span multiple coils and a single position sensor 145 may likewise be positioned between adjacent coils such that a feedback signal is generated when either of the adjacent coils is energized. Each magnetic position sensor 145 generates a feedback signal, having a first waveform, responsive to the drive magnets 130 passing the position sensor 145. The first waveform is a function of the magnetic field generated by the drive magnets. Each magnetic position sensor 145 also generates a feedback signal, having a second waveform, responsive to an electromagnetic field being present in each coil 150. The second waveform is a function of the electromagnetic field generated when the coils 150 are energized to verify electrical connections. The second waveform differs from the first waveform, and both waveforms may be present while driving a mover 100 along the track. As will be discussed in more detail below, in order to diagnose connections between the segment controller 50 and each coil 150, the coil 150 may be energized for a short duration and/or at a different magnitude than the coil would be energized for driving a mover 100. The resultant waveform is provided as a feedback signal to the processor 52 in the segment controller 50.

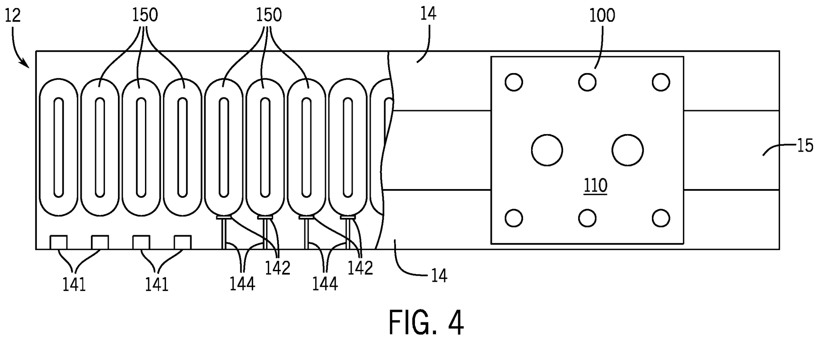

With reference next to Fig. 4, each sensor may be a temperature sensor, configured to generate a feedback signal corresponding to a temperature present in the coil 150. Fig. 4 illustrates both a non-contact temperature sensor 141 and a contact temperature sensor 142. Electrical conductors 144 are shown extending from each contact temperature sensor 142 and may be routed to the feedback circuit 58. The non-contact temperature sensors 141 may similarly include leads (not shown) routed to the feedback circuit 58. Non-contact temperature sensors 141 detect infrared radiation emitted from each coil 150. Contact temperature sensors may be, for example, thermocouples, thermistors, resistance temperature detectors (RTD), or semiconductor (IC) based sensors and generate feedback signals corresponding to a temperature present at the point of contact. A contact temperature sensor may be mounted to insulation of the coil 150 or to a location adjacent to a coil. Current passing through each coil 150 causes the temperature of the coil to increase. Consequently, detecting a change in temperature of a coil 150 in response to energizing the coil indicates correct electrical connections to the coil.

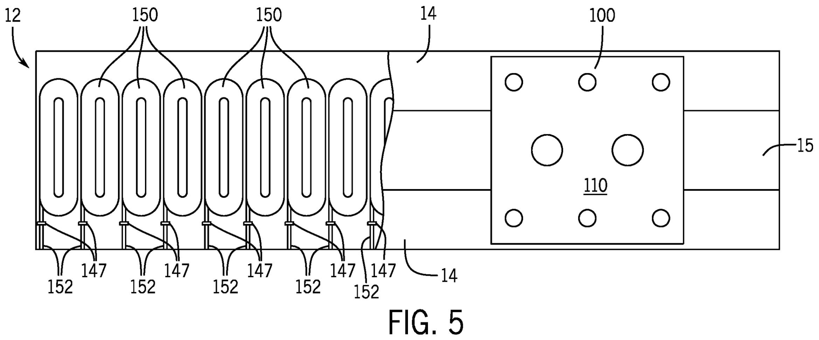

With reference next to Fig. 5, each sensor may be a current sensor 147, configured to generate a feedback signal corresponding to a current flowing in each coil 150. Fig. 5 shows a current sensor 147 mounted to a lead 152 which extends from one leg of the power section to the coil 150. The current sensor 147 generates a feedback signal corresponding to current flowing in the coil 150. Each current sensor 147 is mounted proximate to the coil 150 and after any intermediate electrical connection required between the power section in the segment controller 50 and the coil 150. The location of the current sensor used to diagnose connections is in contrast to the current sensor 151 present in the power section and used to regulate current flow from the power section. Although the feedback signal generated by the current sensor 151 in the power section and the current sensor 147 mounted proximate the coil should indicate generally the same current amplitude at each point, a difference between the two values may indicate an error in electrical connections between the power section and the coil 150.

Although a linear drive system is illustrated in Figs. 3-5, it is contemplated that a similar structure may be implemented within a rotary motor. A magnetic sensor, a thermal sensor, or a current sensor may be included within the motor and mounted in a manner to detect current within one or more coils of the stator of the rotary motor.

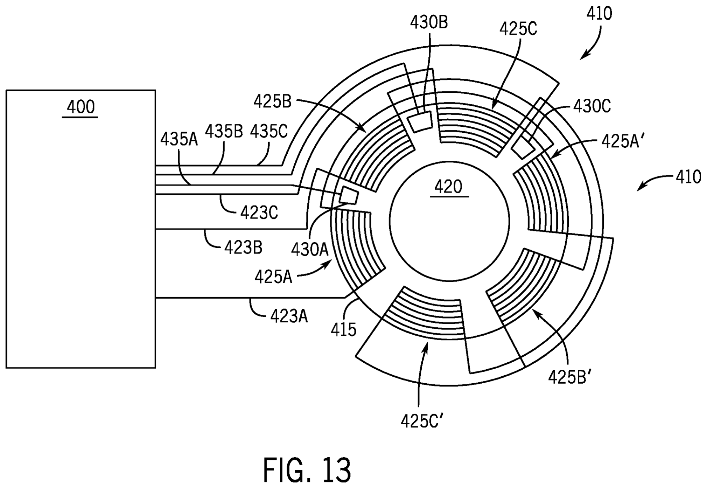

With reference, for example, to Fig. 13, a rotary motor 410 is controlled by a motor drive 400. The rotary motor 410 includes a stator 415 and a rotor 420. The illustrated rotary motor 410 is a three-phase motor, where three power leads 423 are provided between the motor drive 400 and the motor 410. A first power lead 423A supplies power to a first coil 425A. A second power lead 423B supplies power to a second coil 425B. A third power lead 423C supplies power to a third coil 425C. As further illustrated, a first portion 425A of the first coil is wound around a stator tooth on one side of the motor 410 and a second portion 425A' of the first coil is wound around a stator tooth on the opposite side of the motor 410. Although wound around separate teeth, the first portion 425A and the second portion 425A' are electrically connected in series and are considered a single coil for the rotary motor 410. The second coil similarly includes a first portion 425B and a second portion 425B', and the third coil includes a first portion 425C and a second portion 425C'. It is contemplated that various numbers of stator teeth and various numbers of winding segments may be connected in series to create a single coil.

Separate sensors 430 are provided for each coil 425, and feedback signals 435 are transmitted from the motor 410 back to the motor drive 400, where each feedback signal corresponds to operation of one phase of the stator. According to the illustrated embodiment, a single sensor 430 is provided for each coil 425. The first coil 425A has a first sensor 430A mounted proximate to the first coil to detect when current is flowing in the first coil, and the first feedback signal 435A is generated when the first sensor 430A detects the current flowing in the first coil. The second coil 425B has a second sensor 430B mounted proximate to the second coil to detect when current is flowing in the second coil, and the second feedback signal 435B is generated when the second sensor 430B detects the current flowing in the second coil. The third coil 425C has a third sensor 430C mounted proximate to the third coil to detect when current is flowing in the third coil, and the third feedback signal 435C is generated when the third sensor 430C detects the current flowing in the third coil.

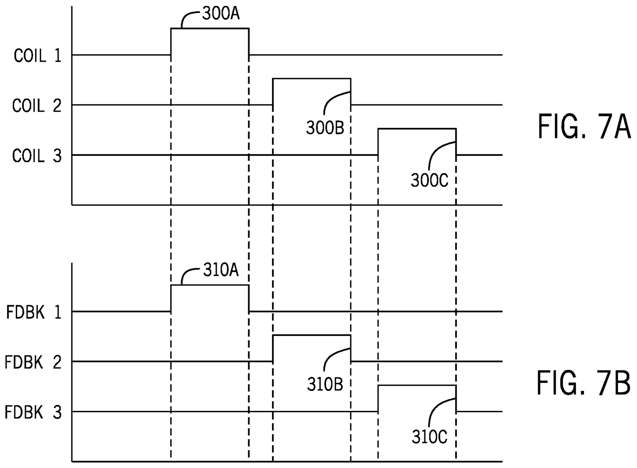

In operation, the segment controller 50 in each track segment 12 provides an improved system and method for diagnosing electrical connections between the power section and each coil 150 along the length of the track segment. The segment controller 50 generates commands to each leg of the power section to individually energize coils 150. According to one aspect of the invention, the coils 150 may be sequentially energized. With reference to Fig. 7A, output commands 300 are generated to three coils. A first output command 300A is provided to a first coil 150, a second output command 300B is provided to a second coil 150, and a third output command 300B is provided to a third coil 150. For ease of discussion, the system and method disclosed herein will be discussed with respect to three coils 150 being energized. A segment controller 50 may generate switching signals 72 for still additional coils 150. Optionally, a segment controller 50 may include multiple inverter sections, where each inverter section is responsible for generating switching signals 72 for three coils. As shown in Fig. 7A, each coil receives a command signal 300 over a predefined duration and each coil 150 is individually energized in sequence from the first coil to the third coil. With reference to Fig. 7B, feedback signals 310 are generated by the sensor being activated which corresponds to the respective coil being energized. A first feedback signal 310A is generated when the first output command 300A is provided to the first coil 150, indicating that the first coil is energized. A second feedback signal 310B is generated when the second output command 300B is provided to the second coil 150, indicating that the second coil is energized. A third feedback signal 310B is generated when the third output command 300B is provided to the third coil 150, indicating that the third coil is energized. Each feedback signal 310 is provided to the segment controller 50. The segment controller 50 compares the feedback signal 310 received to the output command 300 generated to verify that the electrical connections between the segment controller 50 and the coils 150 is correct.

The pattern of command signals 300 and feedback signals in Figs. 7A and 7B illustrate a first test sequence which may be provided to the coils 150. The segment controller 50 sequentially outputs the voltage to individual coils 150 and sequentially receives the feedback signal from each of the plurality of sensors, corresponding to the energized coil. The segment controller 50 is then able to verify that each feedback signal received corresponds to the coil 150 to which the voltage is output. As shown in Figs. 7A and 7B, the feedback signals 310 do correspond to the coils being energized by the command signals 300 and, therefore, the wiring between the segment controller 50 and the coils 150 is correct.

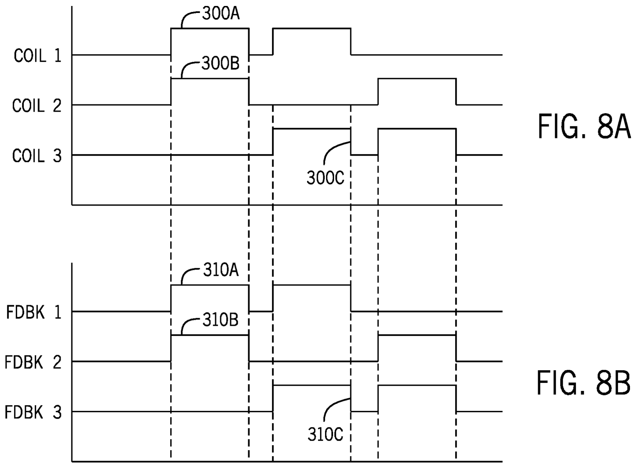

Tuming to Figs. 8A and 8B, a second test sequence of command signals 300 is provided to the coils 150. Rather than sequentially energizing coils 150, the segment controller 50 is configured to energize pairs of coils 150 in tandem. Three discrete time intervals are illustrated. During the first time interval, the first output command 300A and the second output command 300B are provided to the first and second coils, respectively. During the second time interval, the first output command 300A and the third output command 300C are provided to the first and third coils, respectively. During the third time interval, the second output command 300B and the third output command 300C are provided to the second and third coils, respectively. The segment controller 50 still verifies that the electrical connections between the segment controller 50 and each coil 150 are correct by monitoring the feedback signals 310. Figs. 8A and 8B provide another example of correct wiring between the segment controller 50 and the coils. During the first time interval, the first feedback signal 310A and the second feedback signal 310B are present, indicating the first and second coils are energized. During the second time interval, the first feedback signal 310A and the third feedback signal 310C are present, indicating the first and third coils are energized. During the third time interval, the second feedback signal 310B and the third feedback signal 310C are energized, indicating the second and third coils are energized. It is contemplated that coils may be energized sequentially, as illustrated in Figs. 7A and 7B, according to a pattern, as illustrated in Figs. 8A and 8B, or a combination thereof.

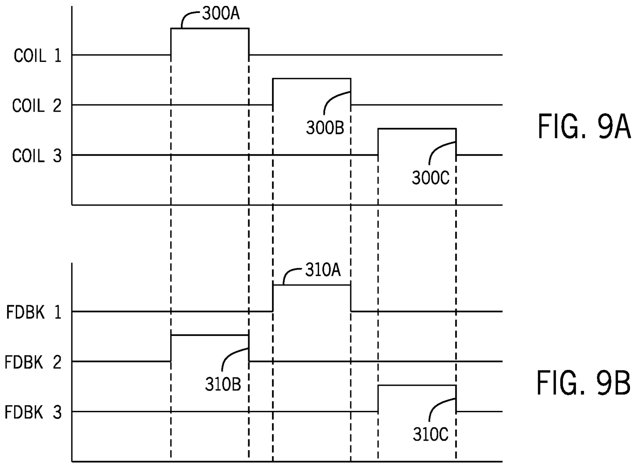

Tuming next to Figs. 9A and 9B, exemplary command signals 300 and feedback signals 310 illustrate an instance in which wiring between two coils 150 is reversed. Just as shown in Fig. 7A, the segment controller 50 sequentially generates commands to each leg of the power section to individually energize coils 150. A first output command 300A is provided to a first coil 150, a second output command 300B is provided to a second coil 150, and a third output command 300B is provided to a third coil 150. However, as shown in Fig. 9B, when the first output command 300A is provided to the first coil, the second feedback signal 310B from the second sensor is generated. When the second output command 300B is provided to the second coil, the first feedback signal 310A from the first sensor is generated. When the third output command 300C is provided to the third coil, the third feedback signal 310C from the third sensor is generated. Thus, only the third feedback signal 310C is generated when it is expected as a function of the output command signals 300. The order of the first and second feedback signals 310A, 310B being generated indicates that there is a fault in the wiring either between the coils 150 and the segment controller or between the sensors and the segment controller 50. The wiring between the coils may be reversed such that the first output command 300A is energizing the second coil and the second output command 300B is energizing the first coil. Alternately, the wiring between the sensors may be reversed such that the first sensor is sending a feedback signal back to the segment controller 50 via the second feedback connection and the second sensor is sending a feedback signal back to the segment controller 50 via the first feedback connection. In either instance, the segment controller 50 is able to detect that the feedback signals 310 received do not correspond to the output commands 300 being supplied to the coils, and a fault message is posted to a technician or operator to check the wiring for the track segment 12.

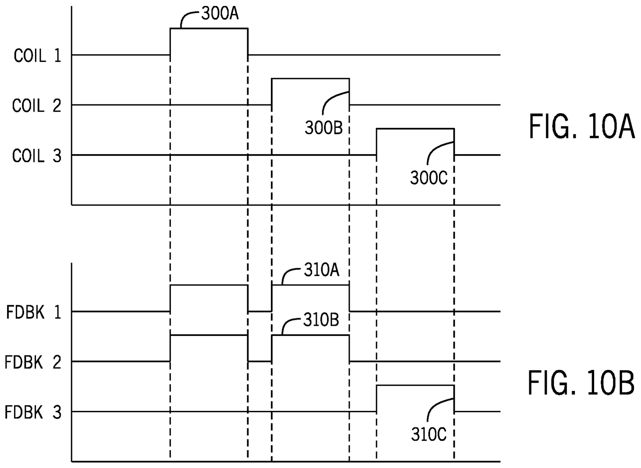

Tuming next to Figs. 10A and 10B, exemplary command signals 300 and feedback signals 310 illustrate an instance in which wiring between two coils 150 is electrically shorted together. Just as shown in Fig. 7A, the segment controller 50 sequentially generates commands to each leg of the power section to individually energize coils 150. A first output command 300A is provided to a first coil 150, a second output command 300B is provided to a second coil 150, and a third output command 300B is provided to a third coil 150. However, as shown in Fig. 10B, when the first output command 300A is provided to the first coil, both the first feedback signal 310A and the second feedback signal 310B are generated. When the second output command 300B is provided to the second coil, both the first feedback signal 310A and the second feedback signal 310B are again generated. When the third output command 300C is provided to the third coil, the third feedback signal 310C from the third sensor is the only feedback signal generated. Because both the first and second feedback signals 310A, 310B are generated when either the first or the second output command 300A, 300B is provided to a coil, it appears that there is a short circuit condition existing between the first and second coils. Each coil generates a field which is detected by the first and second sensors when either coil is energized. The segment controller 50 is able to detect that the feedback signals 310 received do not correspond to the output commands 300 being supplied to the coils, and a fault message is posted to a technician or operator to check the wiring for the track segment 12.

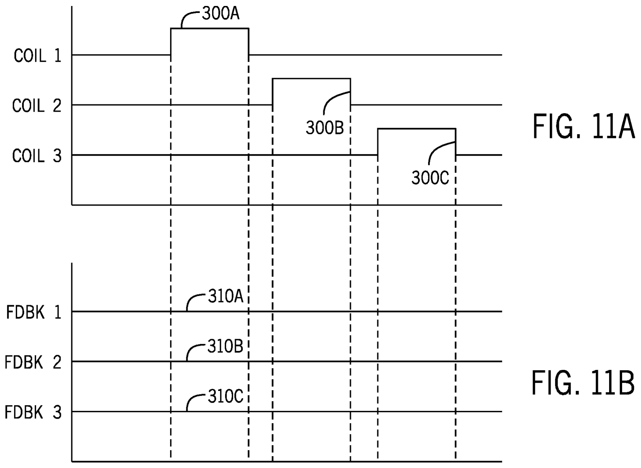

Tuming next to Figs. 11A and 11B, exemplary command signals 300 and feedback signals 310 illustrate an instance in which an electrical connection has not been made or has become disconnected. Just as shown in Fig. 7A, the segment controller 50 sequentially generates commands to each leg of the power section to individually energize coils 150. A first output command 300A is provided to a first coil 150, a second output command 300B is provided to a second coil 150, and a third output command 300B is provided to a third coil 150. However, none of the feedback signals 310A, 310B, 310C change state in response to the output commands 300. Failure to have the feedback signals 310 respond to an output command 300 may indicate that the electrical connection between the segment controller 50 and each coil 150 has not been established. According to one embodiment, cables with connectors extend between the power section of the segment controller 50 and the coils 150. One end of the connector may not be connected or may be seated improperly such that no electrical connection is made. According to another embodiment, cables with leads are inserted into screw terminals at each end of the cable. One or both ends of the cable may be left unconnected or may be improperly inserted into the terminals. Alternately, the sensors may similarly include a cable extending from the sensor to the segment controller 50. One end of the cable for the sensors may be disconnected or improperly seated such that no feedback signal 310 is reaching the segment controller 50. In either case, the segment controller 50 is able to detect that the feedback signals 310 received do not correspond to the output commands 300 being supplied to the coils, and a fault message is posted to a technician or operator to check the wiring for the track segment 12.

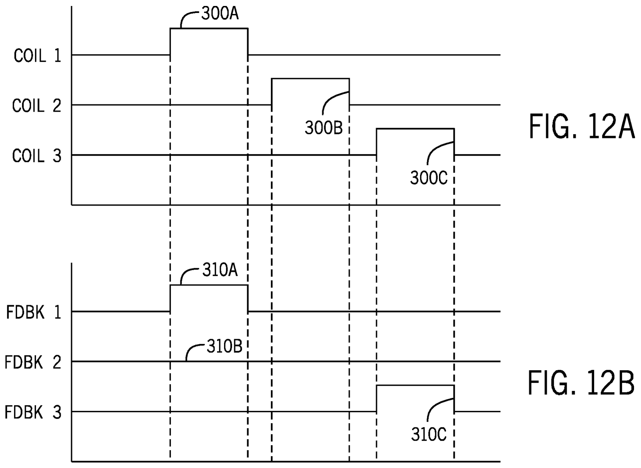

Tuming next to Figs. 12A and 12B, exemplary command signals 300 and feedback signals 310 illustrate an instance in which a single coil has no feedback signal. Just as shown in Fig. 7A, the segment controller 50 sequentially generates commands to each leg of the power section to individually energize coils 150. A first output command 300A is provided to a first coil 150, a second output command 300B is provided to a second coil 150, and a third output command 300B is provided to a third coil 150. When the first output command 300A is provided to the first coil, the sensor is generating the first feedback signal 310A. Similarly, when the third output command 300C is provided to the third coil, the sensor is generating the third feedback signal 310C. However, when the second output command 300B is provided to the second coil, no feedback signal 310B is received at the segment controller 50. Similar, to the case discussed above with respect to Figs. 11A, 11B, the absence of a signal may indicate no electrical connection between the segment controller 50 and the coil 150 or between the sensor and segment controller 50. According to still another failure mode, either the coil 150 or the sensor may have failed. While the electrical connections are in place, either the coil 150 is unable to generate the electromagnetic field or the sensor is unable to detect the coil 150 being energized. The segment controller 50 is able to detect that the feedback signals 310 received do not correspond to the output commands 300 being supplied to the coils, and a fault message is posted to a technician or operator to check the wiring, the coil, and/or the sensors for the track segment 12.

It should be understood that the invention is not limited in its application to the details of construction and arrangements of the components set forth herein. The invention is capable of other embodiments and of being practiced or carried out in various ways. Variations and modifications of the foregoing are within the scope of the present invention. It also being understood that the invention disclosed and defined herein extends to all alternative combinations of two or more of the individual features mentioned or evident from the text and/or drawings. All of these different combinations constitute various alternative aspects of the present invention. The embodiments described herein explain the best modes known for practicing the invention and will enable others skilled in the art to utilize the invention.

In the preceding specification, various embodiments have been described with reference to the accompanying drawings. It will, however, be evident that various modifications and changes may be made thereto, and additional embodiments may be implemented, without departing from the broader scope of the invention as set forth in the claims that follow. The specification and drawings are accordingly to be regarded in an illustrative rather than restrictive sense.

## Claims

1. An apparatus for diagnosing motor connections in an independent cart system, comprising:
a motor including a plurality of coils;
a plurality of sensors mounted in the motor, wherein:
each of the plurality of sensors corresponds to at least one of the plurality of coils, and
each of the plurality of sensors generates a feedback signal corresponding to operation of the corresponding coil; and
a motor controller configured to selectively energize each coil from the plurality of coils to control operation of a mover in the independent cart system, wherein the motor controller is configured to:
output a voltage to each of the plurality of coils,
receive the feedback signal from each of the plurality of sensors, and
verify proper electrical connections between the motor controller and the motor as a function of the voltage output to each of the plurality of coils and of the feedback signal received from each of the plurality of sensors.

2. The apparatus of claim 1, wherein one of:
each of the plurality of sensors is a magnetic field detector mounted proximate the corresponding coil, and
the magnetic field detector is configured to generate the feedback signal responsive to an electromagnetic field generated by current flowing in the corresponding coil;
each of the plurality of sensors is a thermal sensor, and
the thermal sensor is configured to generate the feedback signal responsive to a temperature present in the corresponding coil; and
each of the plurality of sensors is a current sensor, and
the current sensor is configured to generate the feedback signal responsive to a current flowing in the corresponding coil.

3. The apparatus of claim 1 or 2, wherein the motor controller is further configured to:
sequentially output the voltage to individual coils selected from the plurality of coils;
sequentially receive the feedback signal from each of the plurality of sensors; and
verify that each feedback signal received corresponds to the coil to which the voltage is output.

4. The apparatus of one of claims 1 to 3, wherein the mover is operative to travel along a length of the motor responsive to the voltage being output to each of the plurality of coils and wherein the motor controller is further configured to output the voltage to each of the plurality of coils without a mover present on the motor when diagnosing the motor connections.

5. A method for diagnosing motor connections in an independent cart system, wherein the independent cart system includes a plurality of track segments and a plurality of movers operative to travel along the plurality of track segments, the method further comprising the steps of:
energizing a desired coil, selected from a plurality of coils spaced along a length of a track segment, with a segment controller mounted in the track segment, wherein the desired coil varies among each of the plurality of coils according to a diagnostic sequence;
receiving a feedback signal at the segment controller from a sensor mounted on the track segment, wherein:
a plurality of sensors is mounted along the length of the track segment,
each of the plurality of sensors corresponds to at least one of the plurality of coils, and
the feedback signal is generated by the sensor responsive to the corresponding coil being energized by the segment controller; and
verifying that the feedback signal received corresponds to the desired coil being energized.

6. The method of claim 5, wherein:
energizing the desired coil further comprises sequentially energizing each of the plurality of coils as the desired coil;
receiving the feedback signal at the segment controller further comprises the step of sequentially receiving the feedback signal from each of the plurality of sensors when the corresponding coil is energized; and
the method further comprises the step of verifying the motor connections for each track segment are correct when the feedback signal received corresponds to the desired coil being energized.

7. The method of claim 5 or 6, wherein:
energizing the desired coil further comprises energizing a first desired coil and a second desired coil in tandem;
receiving the feedback signal at the segment controller further comprises the step of receiving the feedback signal from a first sensor and a second sensor in tandem at the segment controller; and
verifying that the feedback signal received corresponds to the desired coil further comprises verifying that the feedback signal received from the first sensor corresponds to the first desired coil and that the feedback signal received from the second sensor corresponds to the second desired coil.

8. The method of one of claims 5 to 7, further comprising the step of setting a fault in the segment controller when the feedback signal received does not correspond to the desired coil being energized.

9. The method of claim 8, wherein the fault is selected from one of a swapped connection, a short circuit, and a coil defect.

10. The method of one of claims 5 to 9, wherein one of:
each of the plurality of sensors is a magnetic field detector mounted proximate the corresponding coil, and
the feedback signal is generated responsive to an electromagnetic field generated by current flowing in the corresponding coil;
each of the plurality of sensors is a thermal sensor, and
the feedback signal is generated responsive to a temperature present in the corresponding coil; and
each of the plurality of sensors is a current sensor, and
the feedback signal is generated responsive to a current flowing in the corresponding coil.

11. An apparatus for diagnosing electrical connections in an independent cart system, comprising:
a plurality of movers, wherein:
each of the plurality of movers includes at least one drive magnet, and
the at least one drive magnet defines one portion of a linear drive system to propel the corresponding mover within the independent cart system; and
a plurality of track segments defining a track for the independent cart system along which the plurality of movers travel, wherein each of the plurality of track segments includes:
a plurality of coils extending along a length of the corresponding track segment, wherein the plurality of coils define another portion of the linear drive system to propel the plurality of movers along the track;
a plurality of sensors mounted along the length of the corresponding track segment, wherein:
each of the plurality of sensors corresponds to at least one of the plurality of coils, and
each of the plurality of sensors generates a feedback signal corresponding to operation of the corresponding coil; and
a segment controller configured to:
selectively energize each of the plurality of coils,
receive the feedback signal from each of the plurality of sensors, and
verify proper electrical connections to each of the plurality of coils as a function of the feedback signal received from each sensor and of the selectively energized coils.

12. The apparatus of claim 11, wherein:
the segment controller is configured to energize each of the plurality of coils responsive to a desired motion profile for each of the plurality of movers when propelling the movers along the track, and
the segment controller is configured to energize each of the plurality of coils responsive to a diagnostic sequence when diagnosing the electrical connections.

13. The apparatus of claim 12, at least one of:
wherein the diagnostic sequence includes sequential energization of each of the plurality of coils between a first end and a second end of the corresponding track segment; and
wherein the diagnostic sequence includes energizing at least a first coil and a second coil on the corresponding track segment in tandem.

14. The apparatus of one of claims 11 to 13, wherein:
each of the plurality of track segments further comprises a plurality of position sensors spaced along the length of the track segment,
the plurality of sensors mounted along the length of the track are each one of the plurality of position sensors,
each of the plurality of sensors is operative to detect the at least one drive magnet and to generate a first feedback signal corresponding to the detected drive magnet,
each of the plurality of sensors is operative to detect an electromagnetic field generated when the corresponding coil is energized and to generate a second feedback signal corresponding to the detected electromagnetic field, and
the segment controller is further configured to verify proper electrical connections to each of the plurality of coils as a function of the second feedback signal received from each sensor.

15. The apparatus of claim 14, wherein:
each of the plurality of sensors is operative to detect a current flowing in the corresponding coil, and
the feedback signal generated by each of the plurality of sensors is a function of the current flowing in the corresponding coil.
